# EUROPÄISCHE PATENTSCHRIFT

(11) **EP 0 892 081 B1**
(45) Veröffentlichungstag und Bekanntmachung des Hinweises auf die Patenterteilung: **07.11.2007**
(21) Anmeldenummer: 98111271.7
(22) Anmeldetag: 18.06.1998
(51) Int. Cl.: C23C 14/50, C23C 14/24

(54) **Vakuumbeschichtungsvorrichtung zum allseitigen Beschichten von Substraten durch Rotation der Substrate im Partikelstrom**
Vacuum coating apparatus for all-round coating of substrates by rotation in the particle flux
Dispositif de revêtement sous vide pour revêtir des substrats de tous côtés par rotation des substrats dans le flux particulaire

(30) Priorität: 18.07.1997 DE 19730993
(43) Veröffentlichungstag der Anmeldung: 20.01.1999
(73) Patentinhaber: ALD Vacuum Technologies AG, 63450 Hanau (DE)
(72) Erfinder: Rick, Alfred, 63791 Karlstein (DE); Bähr, Martin, Dr., 63594 Hasselroth (DE); Eberhardt, Helmunt, 63584 Gründau (DE); Anderle, Friedrich, 63452 Hanau am Main (DE)
(74) Vertreter: Hebing, Norbert

(56) Entgegenhaltungen:
- DE-A- 3 934 887
- US-A- 4 108 107
- US-A- 4 485 759
- US-A- 5 558 909

## Beschreibung

Die Erfindung bezieht sich auf eine Vakuumbeschichtungsanlage zum allseitigen Beschichten von Substraten durch Rotation der Substrate in einem Materialstrom, bestehend aus einer Vakuumkammer mit einer Materialquelle, aus einem Substrathalter mit einer Halterung für die Substrate gegenüber der Materialquelle und aus einem dem Substrathalter zugeordneten Antrieb für die Erzeugung einer Rotations- und Verschiebungsbewegung der Substrate, wobei der Substrathalter aus einem in drei sich winklig zueinander erstreckende Schenkel aufgeteilten Hohlprofilzuschnitt gebildet ist, wobei der erste mit dem zweiten Schenkel einen stumpfen Winkel einschließt und der zweite und dritte Schenkel zusammen ein etwa rechtwinkliges Knie bilden, und die Substrate am Ende des dritten Schenkels gehalten sind, wobei die Längsachse des ersten Schenkels etwa den zentralen Bereich der Substrate schneidet und der Substrathalter motorisch angetrieben um die Längsachse des ersten Schenkels rotierbar und darüber hinaus in Richtung dieser Längsachse um eine bestimmte Strecke hin- und herbewegbar ist, und wobei die Substrate mit einer Welle drehfest verbunden sind, die als Gelenkwelle oder als flexible Welle ausgebildet und entlang den Längsachsen der Schenkel durch den Hohlprofilzuschnitt hindurchgeführt ist, und deren freies Ende mit einem Motor in Wirkverbindung steht.

Als Beschichtungsverfahren kommen das Vakuumaufdampfen, Kathodenzerstäubungsverfahren, Ion-Plating, die CVD-Methode (Chemical Vapor Deposition) und verwandte Verfahren in Frage.

Es ist bekannt, Substrate dadurch allseitig mit einer dünnen Oberflächenschicht zu versehen, daß man sie innerhalb eines gerichteten Dampfstroms einer Rotationsbewegung aussetzt und/oder sie unter Ausführung einer Rotationsbewegung durch den Dampfstrom hindurchführt. Zu diesem Zweck können die Substrate einzeln auf Wellen aufgesteckt und um die Wellenachse rotierend in den Dampfstrom gebracht werden. Zum Zwecke eines Antriebs der Wellen werden auf den Wellenenden Zahnräder oder Rollen angebracht, die sich auf einer ortsfesten Zahnstange oder Schiene abwälzen. Auf die angegebene Weise wurden schon Widerstandsschichten auf rohrförmige Isolatoren aufgetragen.

Es ist auch bereits bekannt, geometrische einfache Substrate, wie zum Beispiel optische Linsen und Filter auf Substrathaltern zu befestigen und diese unter Ausführung komplizierter zusammengesetzter Bewegungen periodisch durch den Dampfstrom zu führen. Derartige Vorrichtungen bzw. Verfahren sind nur für relativ kleine Substrate geeignet, deren Formgebung selbst im Hinblick auf eine gleichförmige Schichtdickenverteilung keine Probleme aufwirft.

Zum Zwecke des Bedampfens von relativ komplizierten Teilen, wie beispielsweise von Scheinwerferreflektoren für Kraftfahrzeugscheinwerfer, ist es bereits bekannt, die Substrate auf Substrathaltern anzuordnen, die drehbeweglich in einem im wesentlichen zylindrischen Käfig angeordnet sind. Im Innern des Käfigs befindet sich die Verdampferquelle, so daß bei einer Rotation des Käfigs die Substrate durch den nach oben gerichteten Dampfstrom bewegt werden. Hierbei führen die Substrathalter aufgrund eines überlagerten Antriebs eine zusätzliche Drehbewegung innerhalb des Käfigs aus, die als Evolventenbewegung beschrieben werden kann. Auf die angegeben Weise wird eine recht gute Schichtdickenverteilung nach dem Zufälligkeitsgesetz erreicht. Für extrem unregelmäßig geformte Substrate größerer Abmessungen, die chargenweise mit hochschmelzenden Metallen bzw. Metallegierungen bedampft werden sollen, wobei die Substrattemperaturen oberhalb von beispielsweise 555°C liegen sollen, ist jedoch auch eine derartige Vorrichtung nicht geeignet.

Geometrisch besonders kompliziert geformte Substrate, bei denen auch noch großer Wert auf eine gleichförmige Schichtdickenverteilung, Verteilung der Legierungselemente in der Schicht und eine große Haftfestigkeit durch intermetallische Diffusion gelegt wird, sind beispielsweise Turbinenschaufeln für Gasturbinen, wie sie in der Luftfahrt verwendet werden. Die mit Oberflächenschichten auf derartigen Turbinenschaufeln verbundenen Probleme sind in der Firmendruckschrift "High Temperature Resistant Coatings for Super-Alloy" von Richard P Seeling und Dr. Richard J. Stueber von der Firma CHROMALLOY AMERICAN CORPORATION, New York, USA beschrieben. Es war bisher außerordentlich schwierig, derartige Schichten mit den geforderten Eigenschaften in großtechnischem Maßstab und zu wirtschaftlich vertretbaren Preisen herzustellen. Ein besonderes Problem sind hierbei die Übertragung einer definierten Drehbewegung von einem Antriebsmotor auf ein Substrat sowie die relativ hohen Verluste an teuerem Aufdampfmaterial, welches nicht auf dem Substrat, sondern auf den Innenflächen der Aufdampfanlage kondensiert und dort zu störenden Ablagerungen führt. Diesem Problem kann in gewissem Umfang durch eine räumlich enge Anordnung des Substrats im Dampfstrom bzw. oberhalb des Verdampfertiegels entgegengewirkt werden.

Bekannt ist auch eine Vakuumbeschichtungsanlage zum allseitigen Beschichten von Substraten durch Rotation der Substrate in einem Materialstrom (DE 28 13 180), bestehend aus einer Vakuumkammer mit einer langgestreckten Materialquelle, mit einer Längsachse und einer Querachse, aus einem Substrathalter mit mehreren Befestigungsquelle für die flächige Anordnung mehrerer Substrate oberhalb der Materialquelle, wobei der Substrathalter zwei parallele, gabelförmig angeordnete Tragarme aufweist, deren Längsachsen spiegelsymmetrisch zu einer senkrechten, durch die Längsachse der Materialquelle gehenden Symmetrieebene angeordnet und an den aufeinander zugerichteten Innenseiten der Tragarme Kupplungen für die Substrate angeordnet sind, wobei die Rotationsachsen der Kupplungen senkrecht zur Symmetrieebene ausgerichtet sind, und den Tragarmen in ihrer Längsrichtung je eine Antriebswelle zugeordnet ist, die über Winkelgetriebe einerseits mit den Kupplungen, andererseits mit einem Motor in Verbindung steht.

Bekannt ist schließlich eine Vorrichtung zum Beschichten von dreidimensionalen Substraten mit vergleichsweise großen Abmessungen, insbesondere von Felgen für Autoreifen (US 5,558,909), bei der jeweils zwei Substrate auf einem Träger angeordnet sind, der in der Beschichtungskammer drehbar gelagert ist und eine Z-förmig abgekröpfte mittlere Partie aufweist. Auf einer der schräg zur Rotationsachse des Trägers verlaufenden Abkröpfungen sind die Substrate auf Wellen aufgesteckt, die sich ihrerseits rechtwinklig zu dieser Abkröpfung erstrecken, von der Abkröpfung gehalten und motorisch angetrieben sind. Während des Beschichtungsvorgangs rotiert der Substratträger, wobei die auf die Wellen aufgesteckten Substrate eine Drehbewegung um die Substratträgerachse ausführen und außerdem um ihre eigenen, schräg gestellten Längsachsen rotieren.

Der Erfindung liegt die Aufgabe zugrunde, eine Vakuumbeschichtungsanlage der eingangs beschriebenen Gattung anzugeben, die es ermöglicht, gleichzeitig mehrere kompliziert geformte Substrate, beispielsweise Turbinenschaufeln, besonders gleichmäßig mit metallischen oder oxydischen Oberflächenschichten zu versehen.

Die Lösung der gestellten Aufgabe erfolgt erfindungsgemäß dadurch, daß das freie, mit dem Motor gekoppelte Ende der Welle mit dem Sonnenrad eines Umlaufrädergetriebes fest verbunden ist, wobei des freie Ende des Hohlprofils des Schenkels mit einer Verzahnung versehen ist, mit der mehrere auf einem Sonnenrad gelagerte Planetenräder im eingriff stehen, deren Radachsen jeweils fest mit Substrataufnahmen verbunden sind.

Weitere Merkmale und Einzelheiten sind in den Unteransprüchen näher beschrieben und gekennzeichnet.

Die Erfindung läßt die verschiedensten Ausführungsmöglichkeiten zu; eine davon ist in den anhängenden Zeichnungen rein schematisch näher dargestellt, und zwar zeigen:
- Figur 1: die Vakuumbeschichtungsanlage mit einem Manipulator-Arm zur Halterung von vier Turbinenschaufeln in der Seitenansicht,
- Figur 2: die Anlage gemäß Figur 1, jedoch mit dem um 90° verschwenkten Manipulator-Arm und
- Figur 3: die Draufsicht auf das Planetenrad und die Substrataufnahmen mit den auf ihnen befestigten Turbinenschaufeln gemäß Figur 1.

In einer nicht näher dargestellten Vakuumkammer ist eine Beschichtungsquelle 13 ortsfest angeordnet, die geeignet ist, die Substrate 3,3',3'',3''' im dargestellten Falle vier Turbinenschaufeln, mit einer verschleißfesten und/oder wärmefesten Schicht zu überziehen. Damit die Beschichtung gleichmäßig erfolgt, sind die Substrate 3,3',3'',3''' an einem Substrathalter 6 befestigt, der aus drei Armteilen oder Schenkeln 7,8,9 zusammengefügt ist, von denen die ersten beiden Schenkel 7,8 einen stumpfen Winkel α und der zweite und dritte Schenkel 8 bzw. 9 einen rechten Winkel β miteinander einschließen.

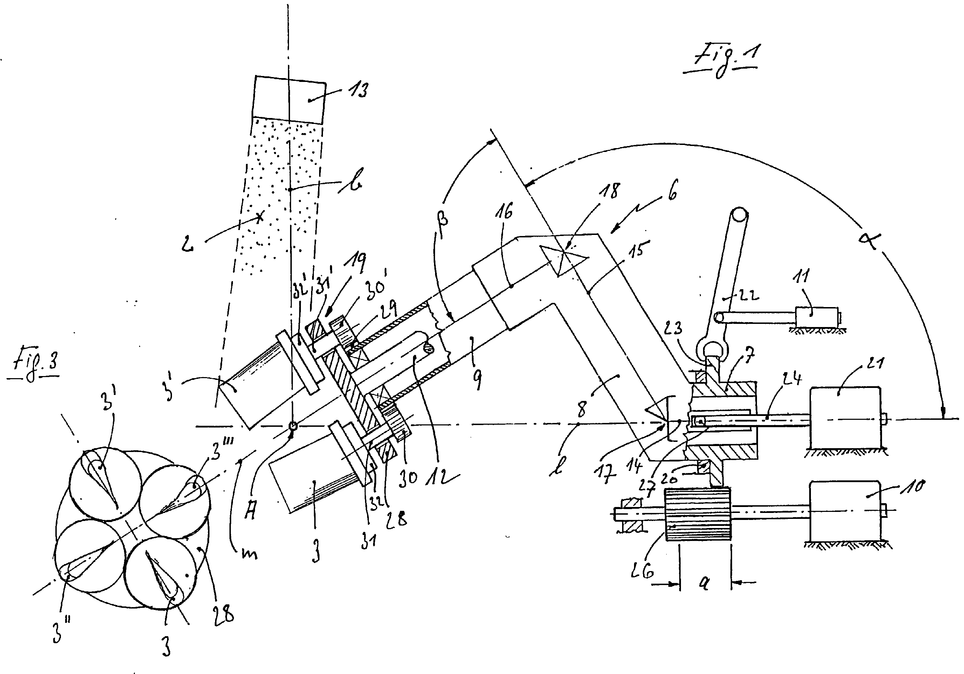

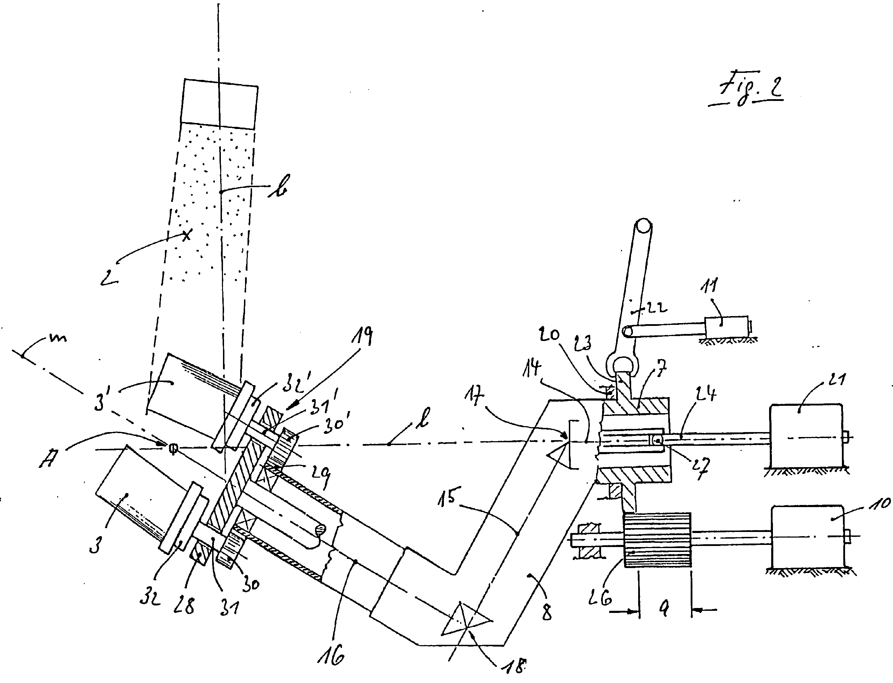

Die Schenkel 7,8,9 sind als Hohlprofile ausgebildet und fest miteinander verbunden oder einteilig ausgebildet. Durch die Längsbohrungen der drei Schenkel 7,8,9 ist eine mehrteilige Antriebswelle 14,15,16 hindurchgeführt, deren einzelne Glieder durch Kegelradpaare 17 bzw. 18 in Wirkverbindung stehen. Die Welle 14 ist von einem Motor 21 angetrieben, dessen Drehbewegungen über die mehrteilige Welle 14,15,16 auf die Substrate 3,3',3'',3''' übertragen werden, wozu die Substrate 3,3', 3'',3''' von einer Halterung 19 am freien Ende der Welle 12 gehalten werden. Die Halterung 19 besteht aus einem Umlaufgetriebe mit einem mit der Welle 16 drehfest verbundenen Sonnenrad 28 und vier auf dem Sonnenrad 28 drehbar gelagerte Planetenrädern 30,30',30'',30''', die mit dem Zahnkranz 29 im Eingriff stehen und die jeweils mit einem Substrataufnehmer 32,32',32'',32''' gekoppelt sind. Die Verzahnung 29 ist mit dem Hohlprofil 9 fest verbunden, das den einen von drei Schenkeln bildet. Der Schenkel 7 ist auf einem Bock 20 drehbar gelagert und kann mit Hilfe des Motors 10 um die Achse 1 gedreht werden, weshalb der Substrathalter 6 die in den Figuren 2 und 3 dargestellten Positionen einnehmen kann. Zusätzlich besteht die Möglichkeit, den Substrathalter 6 um ein Maß a parallel zur Achse 1 zu verschieben, wobei die Substrate 3,3',3'',3''' ebenfalls seinen Gestaltschwerpunkt A um diesen Weg a verändert. Um diese Verschiebung parallel der Achse 1 zu bewirken ist ein Stellmotor 11 vorgesehen, der über eine Stange einen schwenkbar gelagerten Hebel 22 bewegt, dessen Kulisse das Zahnrad 23 übergreift und entsprechend verschiebt. Die Welle 24 des Motors 21 greift über einen Nocken in die Schlitze 25 der Welle 14 ein und steht somit in Wirkverbindung mit der mehrteiligen Welle 14,15,16, die ihre Drehbewegung auf die Substrate 3,3',3'',3''' überträgt, die von den Substrataufnehmern 32,32',32'',32''' gehalten sind. Gegenüber der Wirkachse b der ortsfesten Beschichtungsquelle 13 können die Substrate 3,3',3'',3''' also um das Maß a quer verschoben werden und dabei gleichzeitig auch um die Achse m gedreht werden.

Wie die Figuren 1 und 2 zeigen, können die Substrate 3,3',3",3"' so in ihrer Stellung zur Beschichtungsquelle 13 verschoben und verdreht werden, daß alle Partien der Mantelflächen der Substrate gleichmäßig vom Partikelstrom 2 der Quelle 13 beschichtbar sind. Es ist klar, daß anstelle von den in Figur 3 gezeigten insgesamt vier Substraten 3,3',3'',3''' auch eine andere Anzahl von Substraten vorgesehen werden kann, wenn das Umlaufgetriebe bzw. dessen Sonnenrad 28 mit einer entsprechenden Anzahl von Planetenrädern 30,30',... mit Substrataufnehmern 32,32',... versehen ist.

### Bezugszeichenliste

- 2: Materialstrom, Partikelstrom
- 3,3',...: Substrat
- 4: Materialquelle
- 5: Antrieb
- 6: Substrathalter
- 7: Schenkel
- 8: Schenkel
- 9: Schenkel
- 10: Motor
- 11: Motor
- 12: Welle
- 13: Beschichtungsquelle
- 14: Welle, Glied
- 15: Welle, Glied
- 16: Welle, Glied
- 17: Kegelradpaar
- 18: Kegelradpaar
- 19: Halterung
- 20: Bock
- 21: Motor
- 22: Hebel, Schaltklaue
- 23: Zahnrad
- 24: Welle
- 25: Schlitz
- 26: Ritzel
- 27: Schiebemuffe, Vielkeilwelle
- 28: Sonnenrad
- 29: Verzahnung
- 30,30',...: Planetenrad
- 31,31',...: Radachse
- 32,32',...: Substrataufnahme

## Patentansprüche

1. Vakuumbeschichtungsvorrichtung zum allseitigen Beschichten von Substraten (3,3', 3'',3''') durch Rotation der Substrate in einem Partikelstrom (2), bestehend aus einer Vakuumkammer mit einer Materialquelle (13), aus einem Substrathalter (6) mit einer Halterung (19) für die Substrate (3,3',3'',3''') gegenüber der Materialquelle (13) und aus einem dem Substrathalter (6) zugeordneten Antrieb (10,11,21) für die Erzeugung einer Rotations- und Verschiebebewegung der Substrate, wobei der Substrathalter (6) aus einem in drei sich winklig zueinander erstreckende Schenkel (7,8,9) aufgeteilten Hohlprofilzuschnitt gebildet ist, wobei der erste (7) mit dem zweiten Schenkel (8) einen stumpfen Winkel (α) einschließt und der zweite und dritte Schenkel (8 und 9) zusammen ein etwa rechtwinkliges Knie bilden, und die Substrate (3,3',3'',3''') am Ende des dritten Schenkels (9) gehalten sind, wobei die Längsachse (1) des ersten Schenkels (7) etwa den zentralen Bereich der Substrate schneidet und der Substrathalter (6) motorisch angetrieben um die Längsachse (1) des ersten Schenkels (7) rotierbar und darüber hinaus in Richtung dieser Längsachse (1) um eine bestimmte Strecke (a) hin- und herbewegbar ist, und wobei die Substrate (3,3',3'',3''') mit einer Welle (12) drehfest verbunden sind, die als Gelenkwelle oder als flexible Welle ausgebildet und entlang den Längsachsen der Schenkel (7,8,9) durch den Profilzuschnitt (6) hindurchgeführt ist, und mit ihrem einen Ende mit einem Motor (21) in Wirkverbindung steht, **dadurch gekennzeichnet, daß** das andere Ende der mit einem Motor (21) gekoppelten Welle (12) mit dem Sonnenrad (28) eines Umlaufrädergetriebes fest verbunden ist, wobei das freie Ende des Hohlprofils des Schenkels (9) mit einer Verzahnung (29) versehen ist, mit der mehrere auf dem Sonnenrad (28) gelagerte Planetenräder (30,30',...) im Eingriff stehen, deren Radachsen (31,31',...) jeweils fest mit den Substrataufnahmen (32,32',..) verbunden sind.

2. Vakuumbeschichtungsvorrichtung nach Anspruch 1, **dadurch gekennzeichnet, daß** der erste, dem Substrat (3) abgewandte Schenkel (7) des als Hohlprofilzuschnitt ausgebildeten Substrathalters (6) dreh- und längsverschiebbar in einem ortsfesten Lager (20) gehalten und geführt ist und auf seiner zumindest abschnittsweise zylindrischen Mantelfläche mit einer Verzahnung (23) versehen ist, die mit dem Ritzel (26) einer achsparallelen Antriebswelle eines Motors (10) im Eingriff steht.

3. Vakuumbeschichtungsvorrichtung nach den Ansprüchen 1 und 2, **dadurch gekennzeichnet, daß** das den Substraten (3,3',3'',3''') abgewandte Ende der flexiblen Welle (14,15,16) über ein Vielnutprofil (27) mit der Motorantriebswelle (24) drehfest verbunden ist.

4. Vakuumbeschichtungsvorrichtung nach einem oder mehreren der vorhergehenden Ansprüche, **gekennzeichnet durch** einen Stellmotor (11) mit einer von diesem bewegbaren, den Zahnkranz (23) am ersten Schenkel (7) des Hohlprofils übergreifenden und mit diesem zusammenwirkenden Schaltklaue (22) zum Verschieben des Hohlprofils in seiner Lagerung (20).

5. Vakuumbeschichtungsvorrichtung nach einem oder mehreren der vorhergehenden Ansprüche, **dadurch gekennzeichnet, daß** die Achse (31,31',31'',31''') jedes Planetenrades (30,30',30'',30''') jeweils mit einer als Spannzange ausgebildeten Substrataufnahme (32,32',32'',32''') verbunden ist.

## Claims

1. Vacuum coating apparatus for all-round coating of substrates (3, 3', 3", 3"') by rotation of the substrates in a particle flux (2), consisting of a vacuum chamber with a material source (13), a substrate holder (6) with a mounting arrangement (19) for supporting the substrates (3, 3', 3", 3"') opposite the material source (13), and a drive (10, 11, 21) assigned to the substrate holder (6) for generating a rotating and traversing motion of the substrates, the substrate holder (6) being formed as a hollow section assembly divided into three legs (7, 8, 9) extending at angles to each other with the first leg (7) including an obtuse angle (α) with the second leg (8) and the second and third legs (8 and 9) together forming an approximately right-angled knee and the substrates (3, 3', 3", 3"') being held at the end of the third leg (9), the longitudinal axis (1) of the first leg (7) passing through or close to the central region of the substrates and the substrate holder (6) being motor-driven in rotation about the longitudinal axis (1) of the first leg (7) and being moreover traversable to and fro over a specific distance (a) in the direction of the said longitudinal axis (1), and the substrates (3, 3', 3", 3"') being connected fixedly in rotation to a shaft (12) which is configured as a jointed shaft or flexible shaft and is led through the hollow section assembly (6) along the longitudinal axes of the legs (7, 8, 9) and is actively connected by one end to a motor (21), **characterized in that** the other end of the shaft (12) coupled to the motor (21) is fixedly connected to the sun wheel (28) of a planetary gear train, the free end of the hollow section of the leg (9) being provided with toothing (29) which meshes with a plurality of planet gears (30, 30', ...), mounted on the sun wheel (28), whose axles (31, 31', ...) are respectively fixedly connected to the substrate-receiving sockets (32, 32', ...).

2. Vacuum coating apparatus according to Claim 1, **characterized in that** the first leg (7) of the substrate holder (6) configured as a hollow section assembly (i.e. the leg remote from the substrate (3)) is held and guided rotatably and traversably in a stationary bearing (20) and is provided on its at least partially cylindrical circumferential surface with toothing (23) which meshes with the pinion (26) of an axially parallel drive shaft of a motor (10).

3. Vacuum coating apparatus according to Claims 1 and 2, **characterized in that** the end of the flexible shaft (14, 15, 16) remote from the substrates (3, 3', 3", 3"') is connected fixedly in rotation to the motor drive shaft (24) by splining (27).

4. Vacuum coating apparatus according to one or more of the preceding claims, **characterized by** a servo motor (11) with a shifter fork (22), shiftable by the said motor and straddling the toothed ring (23) on the first leg (7) of the hollow section and cooperating therewith to traverse the hollow section in its bearing (20).

5. Vacuum coating apparatus according to one or more of the preceding claims, **characterized in that** the axle (31,31',31",31"') of each planet gear (30, 30', 30", 30"') is connected to a substrate-receiving socket (32, 32', 32", 32"') configured as a collet chuck.

## Revendications

1. Dispositif de revêtement sous vide pour le revêtement de substrats (3, 3', 3" , 3"') sur tous les côtés par rotation de substrats dans un flux de particules (2), constitué d'une chambre à vide comportant une source de matière (13), d'un porte-substrats (6) avec une attache (19) pour les substrats (3, 3', 3", 3"') par rapport à la source de matière (13), et d'un entraînement (10, 11, 21), associé au porte-substrats (6), pour la production d'un mouvement de rotation et de translation des substrats, le porte-substrats (6) état formé d'un tronçon de profilé creux divisé en trois branches (7, 8, 9) formant un angle l'une par rapport à l'autre, la première branche (7) formant, avec la deuxième (8), un angle obtus et les deuxième et troisième branches (8 et 9) formant ensemble un coude approximativement à angle droit, et les substrats (3, 3', 3", 3"') étant maintenus sur l'extrémité de la troisième branche (9), l'axe longitudinal (1) de la première branche (7) coupant approximativement la zone centrale des substrats et le porte-substrats (6) étant entraîné en rotation par un moteur autour de l'axe longitudinal (1) de la première branche (7) et, par ailleurs, pouvant se déplacer d'un côté et de l'autre d'une certaine distance (a) dans le sens de cet axe longitudinal (1), et les substrats (3, 3', 3", 3"') étant reliés, de manière fixe en rotation, à un arbre (12) en forme d'arbre articulé ou d'arbre flexible et traversant le tronçon de profilé creux (6) le long des axes longitudinaux des branches (7, 8, 9), et son extrémité libre étant en liaison active avec un moteur (21), **caractérisé en ce que** l'autre extrémité de l'arbre (12) couplé à un moteur (21) est reliée solidement à la roue solaire (28) d'un engrenage planétaire, l'extrémité libre du profilé creux de la branche (9) étant pourvue d'une denture (29) dans laquelle s'engagent plusieurs roues planétaires (30, 30', ...) positionnées sur la roue solaire (28), dont les axes (31, 31', ...) sont respectivement reliés solidement aux réceptacles pour substrats (32, 32', ...).

2. Dispositif de revêtement sous vide selon la revendication 1, **caractérisé en ce que** la première branche (7), opposée au substrat (3), du porte-substrats (6) en forme de tronçon de profilé creux, est maintenue et guidée, de manière à pouvoir tourner et à se déplacer sur la longueur, dans un palier stationnaire (20) et pourvue, sur sa chemise, au moins partiellement cylindrique, d'une denture (23) qui s'engage dans le pignon (26) d'un arbre d'entraînement axialement parallèle d'un moteur (10).

3. Dispositif de revêtement sous vide selon les revendications 1 et 2, **caractérisé en ce que** l'extrémité de l'arbre flexible (14, 15, 16) opposée aux substrats (3, 3', 3", 3"') est reliée de manière fixe en rotation à l'arbre d'entraînement du moteur (24) par l'intermédiaire d'un profilé à plusieurs rainures (27).

4. Dispositif de revêtement sous vide selon l'une quelconque ou plusieurs des revendications précédentes, **caractérisé par** un servomoteur (11) comportant une griffe d'accouplement (22) pouvant être mise en mouvement par celui-ci, saisissant par-dessus la couronne dentée (23) sur la première branche (7) du profilé creux et coopérant avec celle-ci, pour déplacer le profilé creux dans son logement (20).

5. Dispositif de revêtement sous vide selon l'une quelconque ou plusieurs des revendications précédentes, **caractérisé en ce que** l'axe (31, 31', 31", 31") de chaque roue planétaire (30, 30', 30" , 31"') est relié respectivement à un réceptacle pour substrats (32, 32', 32" , 32"') en forme de pince.
